Europäisches Patentamt

European Patent Office

Office européen des brevets

(11) Veröffentlichungsnummer: **0 225 457**
**A1**

(12) **EUROPÄISCHE PATENTANMELDUNG**

(21) Anmeldenummer: **86114734.6**

(22) Anmeldetag: **23.10.86**

(51) Int. Cl.⁴: **G03B 27/06** , G03F 7/20

(30) Priorität: **08.11.85 DE 3539690**

(43) Veröffentlichungstag der Anmeldung:
**16.06.87 Patentblatt  87/25**

(84) Benannte Vertragsstaaten:
**BE CH DE FR GB IT LI NL SE**

(71) Anmelder: **BASF Aktiengesellschaft**
**Carl-Bosch-Strasse 38**
**D-6700 Ludwigshafen(DE)**

(72) Erfinder: **Eckle, Albrecht**
**Richard-Wagner-Strasse 42**
**D-6711 Beindersheim(DE)**
Erfinder: **Jaekel, Bernd**
**Dubliner Strasse 12**
**D-6700 Ludwigshafen(DE)**
Erfinder: **Klinsmann, Uwe, Dr.**
**Mollstrasse 39**
**D-6800 Mannheim 1(DE)**
Erfinder: **Britsch, Helmut**
**Westenstrasse 23**
**D-7632 Friesenheim(DE)**

(54) **Gerät zum Belichten von lichtempfindlich beschichteten Materialien.**

(57) Gerät zum Belichten von lichtempfindlich beschichteten Materialien, bestehend aus einer Beladevorrichtung I, einer Vereinzelungs-und Beschickungsstation II, einer Belichtungsstation III, einer Entnahme-und Sammelstation IV und einer Sammeleinrichtung V, wobei mittels des Gerätes ein vollautomatischer Verfahrensablauf des Belichtens von einem Stapel unbelichteter lichtempfindlich beschichteter Materialien zu einem Stapel bildmäßig exakt belichteter lichtempfindlich beschichteter Materialien möglich ist, wobei die Belichtung der Materialien gleichzeitig beidseitig im Kontaktverfahren exakt positioniert bei Unterdrücken von 50 -300 mbar erfolgt.

FIG.1

Xerox Copy Centre

EP 0 225 457 A1

## Gerät zum Belichten von lichtempfindlich beschichteten Materialien

Die Erfindung betrifft ein Gerät zum Belichten von lichtempfindlich beschichteten Materialien, bestehend aus einer Beladevorrichtung, einer Vereinzelungs-und Beschickungsstation, einer Belichtungsstation, einer Entnahme-und Sammelstation und einer Sammeleinrichtung.

Das Belichten von lichtempfindlich beschichteten Materialien, speziell Leiterrohplatten, ist ein Teilprozeß des Verfahrens zur Herstellung von Leiterplatten.

Ursprünglich war die nachfolgend beschriebene Belichtungsart von Leiterrohplatten die allgemein angewandte Methode: Das visuell-manuelle Plazieren von entsprechenden Arbeitsfilmen jeweils auf der Unter-und Oberseite der Leiterrohplatten, das anschließende manuelle Einbringen der so vorbereiteten Leiterrohplatten in das Belichtungsgerät und das abschließende manuelle Entnehmen der belichteten Leiterrohplatten aus dem Belichtungsgerät. Dieser Arbeitsablauf ist aufwendig und kostenintensiv, und daher wird seit dem Jahr 1983 versucht, diese Nachteile mittels Geräten zum vollautomatischen Belichten nach und nach zu beseitigen.

Diesen bis jetzt entwickelten Geräten ist jedoch gemeinsam, daß die Belichtung entweder

a) nicht gleichzeitig beidseitig, oder

b) nicht in innigem Kontakt, wie bei Drücken von 50 -300 mbar erfolgen kann, obwohl beide unter a und b genannten Verfahrensschritte in dem Kopierrahmen gemäß der Patentanmeldung P 31 43 358 beschrieben sind und dieser Kopierrahmen inzwischen vielfach im Einsatz ist.

Der Erfindung liegt daher die Aufgabe zugrunde, die in obigem Kopierrahmen verwirklichten Verfahrensschritte, nämlich den Vorgang des seitherigen manuellen Be-und Entladens der Belichtungseinrichtungen zu automatisieren und dabei speziell zu bewerkstelligen, daß das zu belichtende Material bei Drücken von 50 -300 mbar beidseitig gleichzeitig belichtet werden kann. Des weiteren sollen die Arbeitsfilme/Glasmaster oben und unten unabhängig voneinander in x-y-Richtung positioniert werden können und zusätzlich soll die gesamte Belichtungseinrichtung in staubfreies, gerätebezogenes Klima gestellt werden.

Diese Aufgabe wird erfindungsgemäß dadurch gelöst, daß mittels des Gerätes ein vollautomatischer Verfahrensablauf des Belichtens von einem Stapel unbelichteter lichtempfindlich beschichteter Materialien zu einem Stapel bildmäßig exakt belichteter lichtempfindlich beschichteter Materialien möglich ist, wobei die Belichtung der Materialien gleichzeitig beidseitig im Kontaktverfahren exakt positioniert bei Unterdrücken von 50 -300 mbar erfolgt.

Weitere erfindungsgemäße Merkmale der Erfindung sind Gegenstand der Unteransprüche.

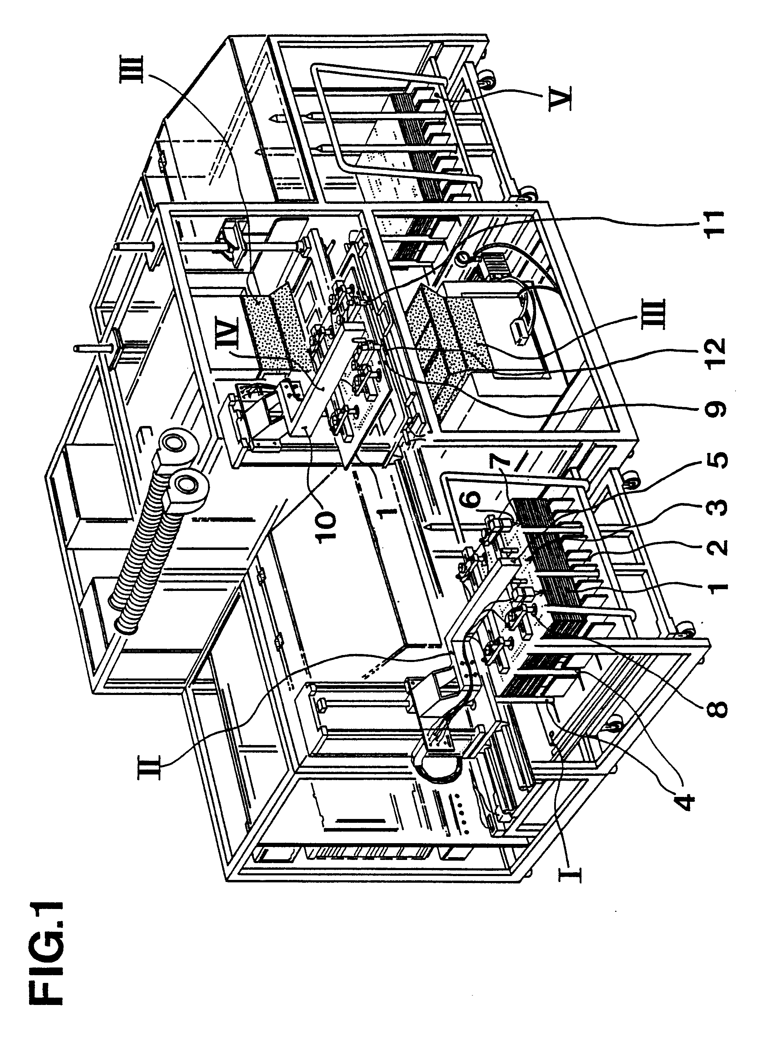

Ein Ausführungsbeispiel der Erfindung mit den wesentlichen erfinderischen Merkmalen ist in der Zeichnung dargestellt und wird im folgenden näher beschrieben. Die Zeichnung zeigt den Aufbau eines Gerätes zum Belichten von lichtempfindlich beschichteten Materialien, speziell Leiterrohplatten, gemäß der Erfindung.

Gemäß der Zeichnung gliedert sich das Gerät in 5 Einzelstationen:

Beladevorrichtung I,

Vereinzelungs-und Beschickungsstation II, (Station II)

Belichtungsstation III,

Entnahme-und Sammelstation IV und

Sammelvorrichtung V.

Beladevorrichtung I: Auf der außerhalb der Station II stehenden Beladevorrichtung wird eine Leiterrohplatte 1 derart grob vorfixiert, daß ein mit der Beladevorrichtung fest verbundener Zentrierstift 2 in eine Bohrung 3 in dieser Leiterrohplatte eingreift. Die anschließende Außenfixierung der Leiterrohplatte erfolgt über exakt geführte, verschiebbare, vertikale Fixierstäbe 4, die nach Anstehen an der Leiterrohplatte mittels Festelleinrichtungen -nicht dargestellt -mit der Beladevorrichtung fest verbunden werden. Diese Außenfixierung der Leiterrohplatte erfolgt mindestens an 3 Seiten. Der so gebildete Käfig wird mit Leiterrohplatten aufgefüllt. Anschließend wird die Beladevorrichtung mit dem fixierten Stapel Leiterrohplatten in die Station II eingefahren und anschließend mittels einer -nicht näher beschriebenen Vorrichtung -derart automatisch fixiert, daß der anschließend beschriebene Arbeitsablauf ermöglicht wird.

Vereinzelungs-und Beschickungsstation II: Der Verfahrensschritt Vereinzeln der Leiterrohplatten aus der Beladevorrichtung heraus bis zum Einlegen in die Belichtungsstation III erfolgt über die Arbeitsgänge Positionieren und Ansaugen der Leiterrohplatte an die Beschickungseinrichtung 5, Hochheben der Leiterrohplatte und horizontales Transpor tieren der Leiterrohplatte in die Belichtungsstation III mittels der Beschickungseinrichtung. Das Positionieren der Leiterrohplatte erfolgt mittels zweier konischer Positionierstifte 6, die in zwei korrespondierende Bohrungen 7 der Leiterrohplatte eingreifen; hiermit erfolgt eine exakte Fixierung an der Beschickungseinrichtung. Ansaugen, Hochheben und Transportieren der Leiterrohplatte in die Belichtungsstation III erfolgt mittels der Ansaugzapfen 8 und der Beschickungseinrichtung 5.

Belichtungsstation III: In der Belichtungsstation III wird die an der Beschickungsvorrichtung haftende Leiterrohplatte wie nachfolgend fixiert: Beim Absetzen der Leiterrohplatte werden zunächst die beiden konischen Positionierstifte 6 in zwei mit diesen Positionierstiften korrespondierende Registerhülsen 9 -die im Unterrahmen der Belichtungseinheit fixiert sind -bis zum Anschlag eingefahren. Nach dem Aufheben des Vakuums an den Ansaugzapfen fällt dadurch die Leiterrohplatte exakt positioniert über die Registerhülsen und wird dann anschließend mittels pneumatisch angetriebener Zylinder -die über die Registerhülsen zum Anlegen an die Leiterrohplatte kommen -gegen den Unterrahmen der Belichtungseinheit gepreßt. Danach wird die Beschickungsvorrichtung aus der Belichtungseinheit ausgefahren, der obere Rahmen der Belichtungseinheit wird über Führungsgestänge nach unten gefahren und die Belichtungseinheit wird geschlossen. Der obere Rahmen ist im Führungsgestänge minimal verschiebbar gelagert. Beim Herunterfahren wird derselbe über zwei Zapfen im Oberrahmen mit zwei korrespondierenden Hülsen im Unterrahmen exakt mit dem Unterrahmen zur Deckung gebracht. Nach Anlagen eines Unterdrucks von 50 bis 300 mbar zwischen Ober- und Unterrahmen der Belichtungseinheit wird die Leiterrohplatte gleichzeitig beidseitig belichtet. Nach dem Belichten wird die Belichtungseinheit geöffnet, der obere Rahmen wird wieder pneumatisch nach oben gefahren und festgehalten, anschließend wird die Entladevorrichtung 10 in die Belichtungseinheit über die zu entnehmende Leiterrohplatte eingefahren und als weiterer Verfahrensschritt drücken Pneumatikzylinder 11 -befestigt an der Entladevorrichtung -die Leiterrohplatte über Kipphebel 12 aus den Registerhülsen.

Entnahme-und Sammelstation IV, Sammelvorrichtung V: Nach dem Aushebeln der Leiterrohplatte wird dieselbe im umgekehrten Verfahrensablauf wie beim Beschicken mittels der Entladevorrichtung aus der Belichtungseinheit heraus über die Entnahme-und Sammelstation IV auf die Sammelvorrichtung V abgelegt.

Es versteht sich von selbst, daß der gesamte Verfahrensablauf mittels eines Computerprogramms gesteuert wird, und daß ohne Unterbrechung Leiterrohplatte für Leiterrohplatte, ca. 150 - 200 Stück pro Stunde -wie beschrieben -aus der Beladevorrichtung über die Belichtungsstation zu der Sammelvorrichtung geführt werden.

Um Unterdrücke von 50 -300 mbar zwischen den Glasscheiben des Ober-und des Unterrahmens der Belichtungseinheit erzeugen zu können, ist es notwendig, die Glasscheiben aus thermisch vorgespanntem Glas auszuführen. Die Position dieser thermisch vorgespannten Glasscheiben ist unabhängig oben/unten über Mikrometerschrauben änder-/einstell-und optimierbar zur Positionierung der auf diese Glasscheiben mittels Kleber übertragenen Arbeitsfilm/Glasmaster auf das Bohrbild der zur Belichtung fixierten Leiterrohplatte.

Um die volle Beweglichkeit der Glasscheiben zum Verstellen bzw. Einpassen zu erhalten, werden aufblasbare Schlauchdichtungen zwischen Ober- bzw. Unterrahmen -gefertigt aus Metall -und Glasscheiben eingebracht, welche zum Verstellen entlüftet, zur Produktion belüftet werden.

Eine weitestgehende Staubfreiheit in der Belichtungsstation -erforderlich für niedrige Ausschußraten -wird dadurch erzielt, daß das Gerät unter minimalen Überdruck mit gefilterter Luft gesetzt wird. Loser Flugstaub kann gegen den ausströmenden Luftstrom nicht in die Belichtungsstation gelangen.

Die vereinzelt in die Belichtungsstation einzufahrende Leiterrohplatte wird unmittelbar vor dem Einfahren beidseitig abgebürstet und abgesaugt.

Um Stillstandszeiten des Gerätes zu minimieren ist es vorteilhaft, daß beispielsweise beim Belichten eines neuen Stapels Leiterrohplatten von anderem Format, das Aufkleben der Arbeitsfilme oder der Glasmaster auf die Glasscheiben außerhalb des Gerätes erfolgt. Hierzu notwendig ist eine zweite separate Rüsteinrichtung, die einfach und absolut exakt in die Belichtungsstation eingebaut werden kann. Der Anschluß der notwendigen Versogungsleitungen und -einrichtungen erfolgt über Schnellverschlüsse.

Für das Aufkleben der positionsgerecht montierten Arbeitsfilme oder Glasmaster werden vorteilhafterweise Sprühkleber verwendet.

Die mit der Erfindung erzielbaren Vorteile bestehen insbesondere in der formatvariablen Systematik, des vollautomatischen Durchlaufs der Leiterrohplatten beim Belichten durch das Gerät, der gleichzeitigen beidseitigen

Belichtung im Kontakt bei 50 -300 mbar, einer hohen Paßgenauigkeit über Verstiftung Ober-Unterrahmen während der Belichtung, der optimalen Justierbarkeit beider Arbeitsfilme/Glasmaster -unabhängig voneinander -durch Stellbarkeit der für Vakuum geeigneten Glasscheiben aus thermisch vorgespanntem Glas und die weitestgehend staubfreie Belichtung.

## Ansprüche

1. Gerät zum Belichten von lichtemfindlich beschichteten Materialien, bestehend aus einer Beladevorrichtung I, einer Vereinzelungs-und Beschickungsstation II, einer Belichtungsstation III, einer Entnahme-und Sammelstation IV und einer Sammeleinrichtung V, dadurch gekennzeichnet, daß mittels des Gerätes ein vollautomatischer Verfahrensablauf des Belichtens von einem Stapel unbelichteter lichtempfindlich beschichteter Materialien zu einem Stapel bildmäßig exakt belichteter lichtempfindlich beschichteter Materialien möglich ist, wobei die Belichtung der Materialien gleichzeitig beidseitig im Kontaktverfahren exakt positioniert bei Unterdrücken von 50 -300 mbar erfolgt.

2. Gerät nach Anspruch 1, dadurch gekennzeichnet, daß mittels des Gerätes das Belichten von lichtempfindlich beschichteten Materialien variabler Formate und Systematik möglich ist.

3. Gerät nach Anspruch 1, dadurch gekennzeichnet, daß auf der Beladevorrichtung I ein Zentrierstift 2 senkrecht zur Grundplatte stehend angeordnet ist.

4. Gerät nach den Ansprüchen 1 und 3, dadurch gekennzeichnet, daß auf der Beladevorrichtung I exakt geführte, verschiebbare, vertikale Fixierstäbe 4 angeordnet sind.

5. Gerät nach den Ansprüchen 1, 3 und 4, dadurch gekennzeichnet, daß die Beschickungseinrichtung 5 der Vereinzelungs-und Beschickungsstation II mit zwei konischen Positionierstiften 6 ausgerüstet ist.

6. Gerät nach den Ansprüchen 1 und 3 bis 5, dadurch gekennzeichnet, daß im Unterrahmen der Belichtungseinheit zwei konische Registerhülsen 9 angeordnet sind.

7. Gerät nach den Ansprüchen 1 und 3 bis 6, dadurch gekennzeichnet, daß am Unterrahmen der Belichtungseinheit zwei Kipphebel 12 angeordnet sind.

8. Gerät nach den Ansprüchen 1 und 3 bis 7, dadurch gekennzeichnet, daß zwischen den Ober- bzw. Unterrahmen der Belichtungseinheit und den Glasscheiben eine aufblasbare Schlauchdichtung eingebracht ist.

9. Gerät nach den Ansprüchen 1 und 3 bis 8, dadurch gekennzeichnet, daß die Glasscheiben der Belichtungsstation III aus thermisch vorgespanntem Glas bestehen.

10. Gerät nach den Ansprüchen 1 und 3 bis 9, dadurch gekennzeichnet, daß am Eingang in die Belichtungsstation III Kohlefaserbürsten angeordnet sind.

11. Gerät nach den Ansprüchen 1 und 3 bis 10, dadurch gekennzeichnet, daß innerhalb der Belichtungseinheit während des Belichtens Ober- und Unterrahmen durch zwei Zapfen im Oberrahmen bzw. zwei korrespondierende Hülsen im Unterrahmen exakt gegeneinander positioniert sind.

12. Gerät nach den Ansprüchen 1 und 3 bis 11, dadurch gekennzeichnet, daß im Belichtungsraum zwischen der aufblasbaren Schlauchdichtung und den thermisch vorgespannten Glasscheiben ein Unterdruck von 50 -300 mbar erzeugbar ist.

13. Gerät nach den Ansprüchen 1 und 3 bis 12, dadurch gekennzeichnet, daß während des Belichtens die Belichtungsstation III unter einem minimalen Überdruck gehalten wird.

14. Gerät nach den Ansprüchen 1 und 3 bis 13, dadurch gekennzeichnet, daß das Gerät mit einer zweiten Rüsteinrichtung für das Aufkleben der Arbeitsfilme oder Glasmaster auf die Glasscheiben ausgerüstet ist.

# FIG.1

O.Z. 0050/38093

0 225 457

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-2 154 011  (ORC MANUFACTURING CO.) * vollständiges Dokument * | 1 | G 03 B  27/06 G 03 F   7/20 |
| | --- | | |
| X | PATENT ABSTRACTS OF JAPAN, Band 8, Nr. 165 (P-291)[1602], 31. Juli 1984; & JP - A - 59 62858 (OOKU SEISAKUSHO) 10.04.1984 | 1 | |
| | --- | | |
| D,A | DE-A-3 143 358  (BASF) * vollständiges Dokument * | 1,9,12 ,14 | |
| | --- | | |
| A | DE-A-3 340 653  (H. HAUS et al.) * Ansprüche 1, 2 * | | |
| | --- | | |
| A | DE-B-2 060 827  (W. STAUB) * Anspruch 1 * | | |
| | ----- | | |

RECHERCHIERTE SACHGEBIETE (Int. Cl.4)

G 03 B  27/00
G 03 F   7/00
G 03 F   9/00

Der vorliegende Recherchenbericht wurde für alle Patentansprüche erstellt.

| Recherchenort | Abschlußdatum der Recherche | Prüfer |
|---|---|---|
| BERLIN | 20-01-1987 | HOPPE H |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82